# EUROPEAN PATENT APPLICATION

(11) **EP 1 499 011 A1**
(43) Date of publication of application: **19.01.2005**
(21) Application number: 03077273.5
(22) Date of filing: 18.07.2003
(51) Int. Cl.: H03F 1/02, H03F 1/32, H03F 3/217

(54) **Amplifying circuit comprising an envelope modulated limit cycles modulator circuit**

(71) Applicant: STICHTING VOOR DE TECHNISCHE WETENSCHAPPEN, 3527 JP Utrecht (NL)
(72) Inventor: Van Roermund, Arthur Hermanus Maria, 5708 KS Helmond (NL); Hegt, Johannes Albertus, 5244 HM Rosmalen (NL)
(74) Representative: Dohmen, Johannes Maria Gerardus

(57) **Abstract**

An amplifying circuit (10) for amplifying a modulated RF input signal, in particular for use in a radio transceiver circuit. The amplifying circuit (10) comprises a limit cycles modulator circuit (20-22, 26-29, 31-33), arranged for generating an amplified RF output signal from an RF input signal, and an envelope modulator circuit (34-36) arranged for amplitude modulating the RF output signal determined by envelope information extracted from the modulated input signal.

## Description

The present invention relates to the amplification of modulated radio frequency (RF) signals, in particular for use in radio transceiver circuits.

Unprecedented demands for higher bandwidth efficiency in RF transmission systems have led to the employment of sophisticated modulation techniques, processing a time-varying phase or frequency and amplitude signal. Use of these modulation techniques requires transceivers having very linear transmission properties in order to process the signal correctly and to suppress interference with adjacent channel transmissions. Maintaining linearity over a wide dynamic range is important for Power Amplifiers (PAs) utilizing power control.

Such modulated signals, however, contain a non-constant envelope, which results in a relatively large envelope peak-to-average ratio. Accordingly, conventional linear-mode PAs, for example class A, AB, or B, have to operate in a region well below the 1-dB compression point. Therefore, power efficiency is very low, resulting in a relatively large power loss or power dissipation in the amplifier. This large power loss can generate serious heating problems in base stations (downlink) of a cellular mobile radio communication system, or may unduly shorten the battery lifetime of handsets (uplink) having transceivers comprising such a PA.

It has been shown that switched-mode PAs can provide a much higher efficiency than linear-mode PAs. Switched-mode PAs, for example operating in class D, E, F or S, make use of a power transistor as a switching element. A proper matching network is needed to only allow the amplified fundamental component to pass through to a load. However, switched-mode PAs are only suitable for amplifying constant-envelope signals. Using these amplifiers to amplify a non-constant envelope signal will lead to loss of amplitude information.

The state-of-the-art technique puts a strong emphasis on the linearization of the highly efficient nonlinear PAs. Known linearization techniques are Cartesian-loop Feedback, Error Feedforward, Predistortion, Linear Amplification using Nonlinear Components (LINC), and Envelope Elimination and Restoration (EER).

Cartesian-loop Feedback splits the feedback signal into quadrature components and processes the error correction in I and Q form, based on the principle of the conventional negative feedback. Cartesian-loop Feedback shows, however, a severe problem with stability and operating bandwidth.

Error Feedforward extracts the distortion generated by a main PA, then amplifies the distortion by an auxiliary amplifier and subsequently subtracts it from the main PA output to leave a linearly amplified version of the input signal. I practice, Error-Feedforward leads to complex circuitry and is inefficient due to the additional error amplifier.

Predistortion creates a distortion characteristic which is precisely complementary to the distortion characteristic of the PA. Predistortion suffers from a limited processing bandwidth of the pre-distorter and is not able to generate a precise enough distortion characteristic of a highly-saturated PA.

LINC splits an RF signal transmission into two constant-envelope phase modulation signals, identically amplifies the signals, each with its own nonlinear switching PA, and then combines the two PA output paths at the summing junction to synthesize the RF signal. However, LINC shows a significant power loss at the output combiner in addition to a mismatch problem between the two signal processing paths around two PAs. The mismatch not only deteriorates the signal properties, but also provides problems with reflected power and thus with heating and burn-out problems.

EER splits an RF signal transmission into two paths: an envelope modulation path, containing only the envelope of the input signal, and a phase modulation path, containing only a constant-envelope phase modulation signal. The phase modulation signal is amplified with a highly efficient PA, and at exactly the same time the envelope signal is restored by modulating the output signal of the PA. EER is limited to a narrow operating bandwidth due to the severe influence of path-delay mismatch between the two signal-processing paths.

Besides that, there is a technique called Limit Cycles Modulation for use as a switched-mode PA. A Limit Cycles Modulator is a self-oscillating circuit comprising a negatively back-coupled nonlinear or relay device which converts an input signal into a discrete-level output signal, for example a two level (1 bit) signal using a switching device. Errors introduced by the relay device are shaped in the frequency domain. The system may only oscillate at a number of discrete frequencies, called limit cycles. Asynchronous Sigma Delta Modulators (ASDM) and the so-called Self-Oscillating Power Amplifier (SOPA) and Delta Modulators are considered a sub-class of Limit Cycles Modulators.

An Asynchronous Sigma Delta Modulator encodes the input signal into a pulse sequence. Due to a relatively high self-oscillating frequency, nonlinear modulation products are located relatively further away from the signal band of interest, so that these unwanted products can be relatively easily filtered out with a relatively low order and/or low-Q RF low pass (LP) or bandpass (BP) filter. However, ASDM suffers from a limited dynamic range of the pulse modulation.

In view of the above-mentioned deficiencies and disadvantages of the prior art amplifying circuits, it is an object of the present invention to provide an improved amplifying circuit for amplifying a time-varying phase or frequency and amplitude modulated RF input signal, optimizing both spectral and power efficiency.

According to the present invention, this object is achieved by an amplifying circuit comprising a limit cycles modulator circuit, arranged for generating an amplified RF output signal from a modulated RF input signal, and an envelope modulator circuit, arranged for amplitude modulating the output signal determined by envelope information of the modulated input signal.

In order to achieve an optimal linearization amplifier in terms of linearity, efficiency, bandwidth and dynamic range, the invention is dedicated to an optimal error control technique of a limit cycles modulator circuit. The invention integrates envelope modulation in the feedforward path of the limit cycles modulator circuit.

Due to the self-oscillating properties of the limit cycles modulator circuit, the RF input signal is modulated in such a manner that nonlinear frequency modulation products are shifted away from the desired frequency signal band, such that these modulation products can be relatively easily filtered out from the output signal. By increasing the switching frequency, a wideband linearization can be obtained. At the same time, the envelope of the input signal is fed into the output signal through the envelope modulator. In this manner, the loop error is controlled in such a way that it becomes proportional to the envelope of the input signal.

The control loop of the limit cycles modulator circuit is capable for correcting the error introduced by the envelope-modulation path. On the other hand, the prediction of the envelope signal reduces the error caused by the relay device of the limit cycles modulator circuit. Accordingly, only the remaining errors need to be corrected by the control loop. As a result, an excellent linearity is achieved at the output and a large dynamic range is obtained, independent of the input power level. Moreover, the amplifying circuit according to the invention relieves the problem of the range limitation that is associated with limit cycles modulation.

In a further embodiment of the invention, the envelope modulator circuit comprises an envelope detector circuit, for extracting the envelope information of the modulated RF input signal. Instead of extracting the envelope information from the RF input signal, in a yet further embodiment according to the invention, the envelope detector circuit is arranged for synthesizing the envelope information from the input signal at baseband.

Although the envelope information may be introduced in the control loop of the limit cycles modulator circuit in a variety of manners, in a preferred embodiment of the invention, the envelope modulator circuit is arranged for powering the limit cycles modulator circuit, for amplitude modulating the output signal. To this end, in another embodiment of the invention, for powering the limit cycles modulator circuit, a power converter circuit is operatively controlled by the envelope information, which power converter, in operation, connects to a power source for powering the amplifying circuit. The power converter circuit may be arranged for controlling either or both the supply voltage or supply current of the limit cycles modulator circuit.

In a preferred embodiment of the invention, the limit cycles modulator circuit takes the form of an asynchronous sigma delta modulator circuit, having a feedback path from the RF output signal to the modulated RF input signal. However, in the case of an input signal available at baseband level, in a still further embodiment of the invention, the asynchronous sigma delta modulator circuit comprises means for providing the modulated RF input signal from the input signal at baseband, and has a negative feedback path from the RF output signal to the input signal at baseband. The feedback path comprises means for down-converting the RF output signal to baseband. For processing the signals at baseband, the amplifying circuit may comprise Digital Signal Processing (DSP) means.

In a further embodiment according to the present invention, the DSP may be advantageously arranged for providing an amount of pre-correction of the input signal, in order to optimize system performance even further. It will be appreciated that for this purpose digital pre-correction means may be separately provided.

The relay device of a limit cycles modulator circuit such as an ASDM, converting the RF input signal into an discrete-level RF output signal, may perform a variety of characteristics. The four main relay types are: the ideal relay, without any delay or hysteresis, a relay having a dead zone wherein no output is provided, a relay with hysteresis and a relay having a dead zone and hysteresis.

As already indicated above, a simple switch such as a transistor may be operated as a relay device, making the system highly efficient. However, the relay device can also be formed by a combination of switching elements, for example for switching the output between three levels: -1, 0 and +1 supporting a balanced configuration of the amplifying circuit according to the invention.

In a preferred embodiment of the invention, the relay device comprises a switched-mode power amplifier arranged for operating in any of the classes: D, E, F or S. In the case of an ASDM circuit, the power amplifier may comprise a reference input for applying a reference signal, such as a DC reference signal or an AC reference signal having a sinewave or a triangular waveform, for example. In another embodiment of the invention, the relay device may also comprise a comparator circuit.

In a yet further embodiment of the invention the limit cycles modulator circuit comprises a loop filter, arranged for optimising linearization performance of the limit cycles modulator circuit. The loop filter may be arranged in the forward loop of the limit cycles modulator circuit, that is in the path connecting the RF input and the relay input, or in the feedback loop. Those skilled in the art will appreciate that the loop filter may be comprised of a plurality of separate filters in either one or both the forward and the feedback loop, whereas the forward and the feedback loop may be comprised by several forward feedback sub-loops, respectively, each performing a particular correction or compensation function.

In order to filter out the unwanted modulation products, the amplifying circuit according to the invention further comprises an RF bandpass filter for providing a band filtered RF output signal. For optimising the power and spectral efficiency of the amplifying circuit of the invention, in another embodiment thereof, the RF bandpass filter means comprise first filter means, optimally arranged for output impedance matching, minimising reflection losses, and second filter means, optimally arranged for RF band filtering.

The first filter means, optimally arranged for output impedance matching, may be arranged at the output of the relay device, incorporated in the control loop of the modulator circuit, while the second filter means, optimally arranged for RF band filtering, connect to the output of the first filter means. Those skilled in the art will appreciate that the second filter means may comprise an LP filter.

The filter means for use in the present invention as well as the other components making up the amplifying circuit as well as their connections, branches and taps, for example, may be constructed using active or passive circuit components in either a lumped or distributed (transmission line) arrangement.

The amplifying circuit according to the present invention is particularly suitable for being completely or partly designed as a semiconductor Integrated Application Specific Circuit (ASIC) and as a Monolithic Microwave Integrated Circuit (MMIC), for example. For use in a radio transceiver circuit such as, but not limited to, a transceiver circuit of a radio access unit, such as a radio base station for use in a mobile radio communication system, and of a handset of such a mobile radio communication system.

Accordingly the invention relates also to a transceiver circuit, a radio access unit and a radio communications unit incorporating an amplifying circuit as disclosed above.

The term transceiver means as used in the present description and the attached claims has to be construed as incorporating transmitter means, receiver means or a combined transmitter/receiver means.

The invention will no be described in more detail with reference to exemplary embodiments shown in the attached drawings.

Figure 1 schematically shows a block diagram of a first embodiment of the amplifying circuit according to the present invention.

Figs. 2-5 schematically show basic operation modi of a relay device for use in the present invention.

Fig. 6 schematically shows a block diagram of a second embodiment of the amplifying circuit according to the present invention.

Fig. 7 schematically shows a block diagram of mobile cellular radio communication system, comprising radio access units and radio communication units having transceiver circuitry comprising the amplifying circuit according to the present invention.

In the following description, throughout the figures, like reference numerals refer to the same or corresponding devices.

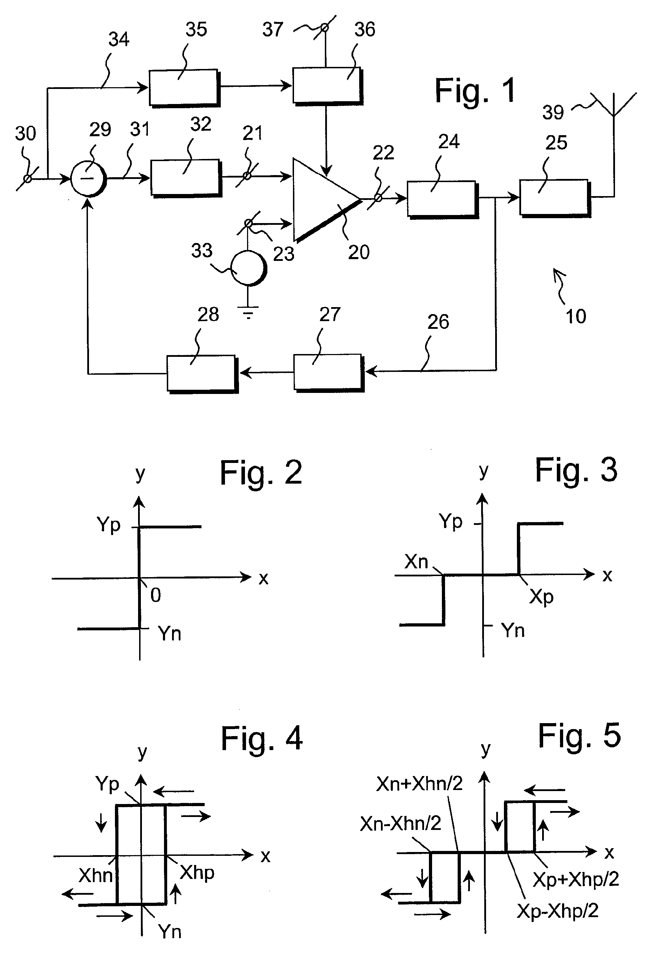

Fig. 1 shows a block diagram of a first general embodiment of an amplifying circuit 10 according to the present invention. The main component of the circuit 10 is formed by a relay device 20. The relay device 20 is a nonlinear element operative for converting a modulated RF input signal, applied at an input terminal 21 of the relay device 20, into a discrete level output signal at an output terminal 22 of the relay device 20.

First filter means 24 and second filter means 25 connect in cascade from the output terminal 22 of the relay device 20 to a load in the form of antenna means 39, for radiating the RF output signal produced at the output terminal 22 of the relay device 20. The antenna means 39 as such do not form part of the amplifying circuit 10.

The first filter means 24 may be optimally configured for impedance matching of the relay device 20, in order to minimise reflection and transmission losses. The second filter means 25 may be optimally configured for RF band selection of the output signal. Those skilled in the art will appreciate that the first and second filter means 24, 25 may be combined into a single RF bandpass filter for providing a band filtered RF output signal. Further, the first and second filter means 24, 25 may comprise a plurality of sub-filters, for example for selecting a plurality of RF transmission bands.

As shown in fig. 1, from the output of the first filter means 24 a feedback loop 26 connects to an input of subtraction means 29, at another input of which an RF input terminal 30 is connected, for receiving a modulated RF input signal to be amplified by the amplifying circuit 10. An output of the subtraction means 29 connects by a forward loop 31 to the input terminal 21 of the relay device 20.

In the feedback loop 26 third filter means 27 and/or gain control means 28 may be arranged and in the forward loop 31 fourth filter means 32 may be arranged, as shown in fig. 1. The third and fourth filter means 27, 32 may be comprised of several sub-filters and, together, form loop filter means of a closed control loop of the relay device 20 formed by the forward loop 31 and the feedback loop 26. The control loop is arranged such that a self-oscillating limit cycles modulator circuit is provided which may oscillate at a number of discrete frequencies, called limit cycles.

Although not mandatory, the oscillation frequency of the modulator circuit thus formed may be controlled by applying a reference signal at a further input terminal 23 of the relay device 20 from a signal source 33, for example. This reference signal may be a Direct Current (DC) or an Alternating Current (AC) signal, such as a triangular wave signal.

The relay device 20 may be arranged for operating according to any of four basic conversion modes, as schematically shown in figures 2, 3, 4 and 5. In these figures, on the horizontal axis, represents x the input signal and on the vertical axis represents y the output signal. Because of their illustrative nature, no specific amplitude values for the input and output signals have been indicated. The input signal x of the relay device 20 is in general formed by a combination of the input signals at the input terminals 21 and 23.

In the ideal relay mode of fig. 2, the output signal y toggles without delay between a positive Yp and a negative amplitude value Yn for each zero-crossing of the input signal x. In the mode with dead zone, fig. 3, the output signal y changes state for each transition of the input signal x, provided the absolute value of the amplitude of the input signal is above a predetermined threshold value Xp or Xn, which may be different for positive or negative values of the input signal amplitude. For input signal amplitudes between the threshold values Xp and Xn, an output signal zero is provided. In the relay mode with hysteresis, fig. 4, the output signal y toggles between the positive and negative amplitude value Yp and Yn for input signal transitions above or below pre-determined threshold values Xhp and Xhn. The arrows indicate the change of the output signal for a transition of the input signal from positive to negative and vice versa. In the combined mode as shown in fig. 5, in addition to the relay with hysteresis, the output signal y may take the value zero for input signal values in the dead zone between Xp-Xhp/2 and Xn+Xhn/2. In which mode the relay device should operate depends on the required characteristics of the amplifying circuit 10, and may be application dependent.

For the purpose of the present invention, a relay device 20 comprised of a switched-mode power amplifier, operating in any of the classes: D, E, F or S or a relay device 20 comprised of a comparator circuit is particularly feasible. However, it should be understood that the invention is not limited to such types of relay elements. For the purpose of the present invention, a wide variety of relay devices or nonlinear elements may be used as known to those skilled in the art. Reference is made to the book "Multiple-Input Describing Functions and Nonlinear System Design", by Arthur Gelb and Wallace E. van der Velde, Published by McGraw-Hill, London 1968, in particular Chapter 3 Steady-State Oscillations in Nonlinear Systems, which is herein incorporated by reference.

In the case of a relay device 20 in the form of a comparator and by applying a DC reference voltage at input terminal 23 of the relay device 20, a limit cycles modulator circuit is formed which is called an Asynchronous Sigma Delta Modulator (ASDM). For completeness sake, the external reference signal may also be absent. In the case of, for example, a relay device in the form of a single high gain transistor the threshold voltage of the transistor operates as an internal reference supporting the operation as ASDM.

In operation of the modulator circuit thus described, and in the absence of any input signal, self-oscillation will occur yielding a periodical rectangular waveform at the self-oscillation frequency of the modulator, i.e. the limit cycle. The oscillation frequency, among others, depends on the properties of the filter means 27, 28, 32 in the control loop of the modulator circuit. The modulator circuit encodes the RF input signal applied at the RF input terminal 30 into a pulse sequence, in such a manner that nonlinear modulation products are located away from the signal band of interest.

These nonlinear modulation products can be filtered out by the bandpass filter means at the output terminal 22 of the relay element 20, i.e. the first and second filter means 24, 25 disclosed above. Linearization can be optimised by suitably selecting the filter means 27, 28, 32 in the control loop of the modulator circuit. By increasing the oscillation frequency, low-Q and low order filter means can be used, such that a wideband linearization can be obtained.

In the case of a triangular reference signal applied at the input terminal 23 of the relay device 20, formed as a comparator, and in the absence of the feedback loop 26, in operation, the limit cycles modulator circuit would provide a Pulse Width Modulated (PWM) output signal. However, by the feedback loop 26, the output signal is modified such that in the frequency band of interest same equals the input signal.

However, in the case of an envelope modulated RF input signal, a significant error in the output signal will occur, mainly due to the limited dynamic range of the pulse modulation of the limit cycles modulator circuit. To improve the error control of the limit cycles modulator circuit, according to the present invention, a further forward loop 34 is added in the form of an envelope modulator circuit.

In the embodiment shown in fig. 1, the envelope modulator circuit comprises an envelope detector circuit 35, an input of which connects to the RF input terminal 30, for extracting envelope information from the modulated RF input signal. The envelope detector circuit 35 controls a power converter circuit 36, arranged for modulating the output signal produced by the relay device 20 at its output terminal 22.

In the embodiment disclosed in fig. 1, the power converter circuit 36 is arranged for modulating the supply power, i.e the supply voltage and/or the supply current of the relay element, applied at a power terminal 37 of the amplifying circuit 10 in accordance with the envelope information extracted by the envelope detector circuit 35. Dependent on the type of modulation control provided, the power converter circuit 36 may be arranged as a DC/DC voltage or current converter circuit, for example. However, the invention is not limited to this type of modulation of the relay element 20. Other types of amplitude modulation of the output signal of the relay element 20 may be applied too, such as known by those skilled in the art.

In the manner disclosed above, in accordance with the invention, the loop error of the modulator circuit is controlled in such a manner that same becomes proportional to the envelope of the RF input signal. As a result, a much larger dynamic range is obtained compared to the modulator circuit without the envelope forward loop 34. The feedback loop 26 of the modulator circuit is capable for correcting the error left by the envelope modulation circuit 35, 36. Further, by the prediction of the envelope signal through the envelope forward loop 34, the nonlinear signal components of the modulator circuit are reduced, resulting in an improved linearity of the amplifying circuit 10.

Envelope detector or extraction circuits are known to those skilled in the art and need no further explanation here. The same applies for converter circuits for modulating the amplitude of the relay circuit 20. In an embodiment of the invention, the converter circuit 36 comprises a switch mode amplifier.

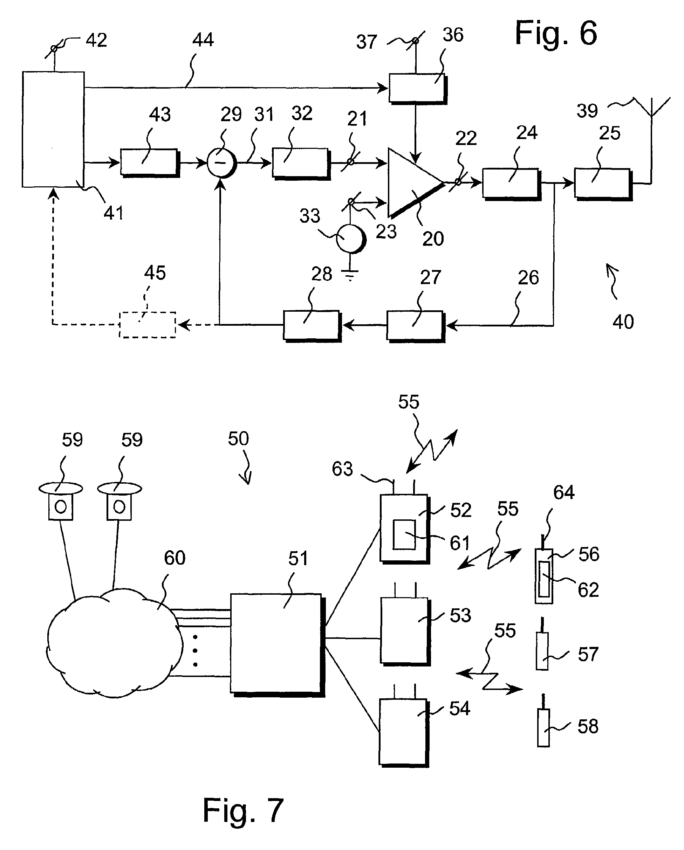

Fig. 6 shows a second embodiment of an amplifying circuit 40 according to the present invention. In this embodiment, envelope information is extracted from a baseband modulated input signal applied at a baseband input terminal 42 of an envelope synthesizing circuit 41, such as Digital Signal Processing (DSP) means. The envelope information thus extracted is provided via an envelope forward loop 44 form the synthesizing circuit 41 to the power detector circuit 36 for amplitude modulation of the output signal of the relay device 20.

By up-converter means 43, an input of which connects to a signal output of the synthesizing circuit 41, a modulated RF input signal is applied to the forward loop 31 of the limit cycles modulator circuit.

The feedback loop 26 of the limit cycles modulator circuit, in a further embodiment of the invention, may be directly applied to the synthesizing circuit 41. To this end, down converter means 45 are provided, shown in dotted lines in fig. 6, for down conversion of the feedback signal to baseband for processing by the synthesizing circuit 41. It will appreciated that when applying the down converter means 45, the connection of the gain control means 28 to the subtraction means 29 will be skipped. Suitable down conversion means for this purpose are known to the person skilled in the art. Note that in the embodiments of figs. 1 and 6 the subtraction means 29 may be replaced by summation means if the gain control means 28 provide an inverted (negative) output, for example.

The synthesizing circuit 41, in a yet further embodiment of the invention, may be arranged or may comprise means for providing a certain amount of pre-correction at baseband level to the input signal to be applied to the forward loop 31 of the limit cycles modulator circuit, in order to even increase the performance of the amplifying circuit 40. Suitable synthesizing means and/or pre-correction means are known to those skilled in the art.

The amplifying circuit according to the present invention is particularly suitable for use in radio transceiver devices, such as those used in mobile radio communication, for example operating in accordance with the Universal Mobile Telecommunication System (UMTS) Wideband Code Division Multiple Access (WCDMA) standards.

Fig. 7 shows in a very schematic form a mobile radio communication system 50, comprising a Mobile Telephone Switching Office (MTSO) 51 or radio exchange which connects to a landline telephone network 60, such as the Public Switched telephone Network (PSTN) or the Integrated Services Digital Network (ISDN) to which a plurality of landline users 59 connect.

The MTSO 51 supports a plurality of radio access units or base stations 52, 53, 54 and remote radio communication units 56, 57, 58 such as, but not limited to radio telephone handsets arranged for radio communication through an air interface 55. In accordance with the present invention, the radio access unit 52 comprises transceiver means 61 having an amplifying circuit 30 or 40 as disclosed and described above in accordance with the present invention, connecting to antenna means 63 for RF radio transmission. Likewise, the radio communication unit 56 comprises transceiver means having an amplifying circuit 30 or 40 in accordance with the present invention, connecting to antenna means 64.

The filter means, because of the possibility of using low order and low-Q filters, may be constructed as active, passive, lumped or distributed filters. Likewise, the other components making up the amplifying circuit as well as their connections, branches and taps, for example, may be constructed using active or passive circuit components in either a lumped or distributed (transmission line) arrangement.

The amplifying circuit according to the present invention is particularly suitable for being completely or partly designed as a semiconductor Integrated Application Specific Circuit (ASIC) and as a Monolithic Microwave Integrated Circuit (MMIC), for example.

Although the invention has been described and disclosed above using exemplary embodiments thereof, it will be appreciated that those skilled in the art can be made numerous amendments and additions to the arrangements disclosed, however without departing form the novel and inventive concept of the present invention as disclosed and claimed in the attached claims.

## Claims

1. An amplifying circuit for amplifying a modulated RF input signal, in particular for use in a radio transceiver circuit, said amplifying circuit comprising a limit cycles modulator circuit, arranged for generating an amplified RF output signal from said input signal, and an envelope modulator circuit arranged for amplitude modulating said output signal determined by envelope information of said modulated input signal.

2. An amplifying circuit according to Claim 1, wherein said envelope modulator circuit comprises an envelope detector circuit, for extracting said envelope information from said modulated RF input signal.

3. An amplifying circuit according to Claim 1, wherein said envelope detector circuit is arranged for synthesizing said envelope information from said input signal at baseband.

4. An amplifying circuit according to any of the previous claims, wherein said envelope modulator circuit is arranged for powering said limit cycles modulator circuit, for amplitude modulating said output signal.

5. An amplifying circuit according to Claim 4, comprising a power converter circuit for powering said limit cycles modulator circuit, wherein said power converter circuit is operatively controlled by said envelope information.

6. An amplifying circuit according to Claim 5, wherein said power converter circuit comprises a switched-mode power amplifier.

7. An amplifying circuit according to any of the previous claims, wherein said limit cycles modulator circuit comprises an asynchronous sigma delta modulator circuit, having a feedback path from said RF output signal to said modulated RF input signal.

8. An amplifying circuit according to any of the Claims 1-6, wherein said limit cycles modulator circuit comprises an asynchronous sigma delta modulator circuit, comprising means for providing said modulated RF input signal from an input signal at baseband, and a feedback path from said RF output signal to said input signal at baseband.

9. An amplifying circuit according to Claim 8, wherein said feedback path comprises means for down-converting said RF output signal to baseband.

10. An amplifying circuit according to any of the previous claims dependent on any of the Claims 3, 8 or 9, comprising digital signal processing means for processing said input signals at baseband.

11. An amplifying circuit according to any of the previous claims, comprising pre-correction means for pre-correction of said input signal.

12. An amplifying circuit according to Claim 11, dependent on any of the Claims 3, 8, 9 or 10, wherein said pre-correction means comprise digital signal processing means for pre-correcting said input signal at baseband.

13. An amplifying circuit according to any of the previous claims, wherein said limit cycles modulator circuit comprises a relay device for converting said RF input signal into an discrete-level RF output signal, said relay device being arranged for performing a function of any of a group comprising: an ideal relay, a relay having a dead zone, a relay with hysteresis and a relay having a dead zone and hysteresis.

14. An amplifying circuit according to Claim 13, wherein said relay device comprises a switched-mode power amplifier arranged for operating in any of the classes: D, E, F or S.

15. An amplifying circuit according to Claim 14, wherein said power amplifier comprises a reference input for applying a reference signal.

16. An amplifying circuit according to Claim 12, wherein said relay device comprises a comparator circuit.

17. An amplifying circuit according to any of the previous claims, wherein said limit cycles modulator circuit comprises a control loop filter, arranged for optimising linearization performance of said modulator circuit.

18. An amplifying circuit according to any of the previous claims, further comprising an RF bandpass filter for providing a band filtered RF output signal.

19. An amplifying circuit according to Claim 18, wherein said RF bandpass filter means comprises first filter means optimally arranged for output impedance matching and second filter means optimally arranged for RF band filtering.

20. An amplifying circuit according to Claim 19, wherein said first filter means are arranged in said control loop, and wherein said second filter means connected to said first filter means.

21. An amplifying circuit according to any of the previous claims, designed as semiconductor Integrated Application Specific Circuit (ASIC).

22. An amplifying circuit according to any of the Claims 1-20, designed as and as a Monolithic Microwave Integrated Circuit (MMIC)

23. A radio transceiver circuit comprising an amplifying circuit according to any of the previous claims.

24. A radio access unit, such as a radio base station for use in a mobile radio communication system, said radio access unit comprising a radio transceiver circuit according to Claim 23.

25. A radio communication unit, such as a handset of a mobile radio communication system, said handset comprising a radio transceiver circuit according to Claim 23.
